(19) **Europäisches Patentamt / European Patent Office / Office européen des brevets**

(11) **EP 4 057 017 A1**

(12) ## EUROPEAN PATENT APPLICATION

(43) Date of publication:
**14.09.2022 Bulletin 2022/37**

(21) Application number: **21161626.3**

(22) Date of filing: **09.03.2021**

(51) International Patent Classification (IPC):
**$G01R\ 31/367^{(2019.01)}$      $H02J\ 7/00^{(2006.01)}$**

(52) Cooperative Patent Classification (CPC):
**G01R 31/367; H02J 7/0047; H02J 7/00712**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Université Libre de Bruxelles**
**1050 Bruxelles (BE)**

(72) Inventors:
• **GARONE, Emanuele**
**1560 Hoeilaart (BE)**

• **GOLDAR, Alejandro**
**1050 Ixelles (BE)**
• **COUTO, Luis Daniel**
**1560 Hoeilaart (BE)**
• **ROMERO FREIRE, Alberto**
**4040 Linz (AT)**
• **KINNAERT, Michel**
**1170 Brussels (BE)**

(74) Representative: **ABYOO**
**Centre Monnet**
**Avenue Jean Monnet 1**
**1348 Louvain-La-Neuve (BE)**

(54) **METHOD AND DEVICE FOR CONTROLLING A CHARGING SIGNAL FOR CHARGING A RECHARGEABLE BATTERY CELL**

(57)    The present disclosure relates to a method for controlling a charging signal for charging a rechargeable battery cell. Based on a dynamic electrochemical model, a functional or tabular relation is defined allowing to compute a maximum charging value for the charging signal such that if the charging signal is smaller than or equal to the maximum charging value during a charging time period of the battery cell, the constraints of a constraint model are satisfied during the charging time period. As long as the battery cell has not reached an end-of-charge condition, the battery cell is being charged by applying a closed-loop charging method comprising repetitively performing: i) measuring one or more measurable signals of the battery cell, ii) using a state observer algorithm for estimating one or more of state variables of the model, and wherein the state observer algorithm is using the one or more measured measurable signals as an input and provides estimates of the one more state variables as output, iii) using the functional or tabular relation for computing the maximum charging value by using at least the estimates of the one or more state variables resulting from step ii) as an input for the functional or tabular relation, and iv) applying a charging signal to the battery cell that is equal to or lower than the maximum charging value as determined in step iii). The present disclosure also relates to a charging device implementing the charging method.

Fig. 1

**EP 4 057 017 A1**

**Description**

**Field of the disclosure**

The present disclosure relates to a method for charging a rechargeable battery cell or a rechargeable battery. More specifically, a charging method that makes use of a dynamic electrochemical model of the rechargeable battery cell or of the rechargeable battery. The present disclosure also relates to a device for charging a rechargeable battery cell or a rechargeable battery.

**Background**

Rechargeable battery cells or batteries are presently widespread in many devices ranging from portable electronic devices to electric vehicles. Due to their importance, in the last few decades batteries have been the subject of a constant research effort aimed at enhancing their performance in terms of storage capacity, time of charge, and lifetime.

In embodiments, multiple rechargeable battery cells are grouped in series and/or parallel for forming a battery such as for example a battery pack or a battery module.

Among the commercially available rechargeable storage devices, battery cells based on Lithium-ion (Li-ion) technology are currently the most performing type of battery cells.

For charging rechargeable battery cells, e.g. Li-ion battery cells, various charging protocols have been proposed. A widely used battery charging protocol is the so-called Constant Current-Constant Voltage (CC-CV). This protocol comprises two steps wherein during a first step a constant current is applied to the battery cell until the voltage reaches a pre-defined voltage threshold. Thereafter, during a second step, the battery cell is kept at a constant voltage until the current drops below a current threshold.

A major drawback of the CC-CV protocol is that it is an ad-hoc method wherein the parameters, e.g. charging current and current and voltage thresholds, are usually determined heuristically. Furthermore, for safety reasons, these parameters are typically tuned in a conservative way. As a consequence, charging times and lifetimes of the batteries are not optimized and degradation mechanisms of the batteries are not explicitly taken into account.

In the academic world, protocols have been proposed based on the model predictive control (MPC) approach combined with dynamic electrochemical models in order to reduce the charging time and to actively limit the occurrence of the degradation phenomena. An example of an electrochemical model, describing the dynamics of the battery cell is, for example, the Doyle-Fuller-Newman model. At each sampling time the MPC approach solves an optimization problem based on the electrochemical model of the battery for calculating in real time the charging current to be applied on the battery at each time instant.

A major problem with the use of an MPC approach based on an electrochemical model is that, while interesting from a theoretical point of view, they add a large computational complexity. Hence embedded electronics with high computational power is required to implement these kind of constrained control algorithms. This would significantly increase the cost of the Battery Management System and therefore, this approach cannot be followed for low-cost devices for example.

Hence, there is room for improving charging protocols (methods) for rechargeable battery cells and batteries.

**Summary**

An object of the present disclosure is to provide a fast closed-loop charging method for a rechargeable battery cell which takes into account degradation phenomena of the battery cell. It is a further object to reduce the required computational power and hence reduce the hardware cost of battery chargers. Furthermore, the battery chargers of the present disclosure charges the battery cell or battery in a faster and yet safe way.

The present invention is defined in the appended independent claims. The dependent claims define advantageous embodiments.

According to a first aspect of the invention, a method for controlling a charging signal applied to a rechargeable battery cell for charging the rechargeable battery cell is provided.

The method of the present disclosure comprises:

a) providing a dynamic electrochemical model for modelling the charging of the rechargeable battery cell, wherein the dynamic electrochemical model is configured for describing a dynamic behavior of one or more state variables of the dynamic electrochemical model and of one or more measurable signals of the rechargeable battery cell, and wherein the dynamic electrochemical model comprises a constraint model defining constraints on one or more quantities, wherein the one or more quantities are any of but not limited to: one or more of the state variables, the charging signal, one or more internal parameters and/or one or more external variables, and wherein the constraints describe battery cell operational regions which avoid or limit occurrence of one or more battery cell degradation phenomena,

b) defining a functional or a tabular relation that is taking as input one or more input quantities and that is providing as output a maximum charging value for the charging signal, and wherein the one or more input quantities comprises any of: one or more of the state variables, one or more of the measurable signals, one or more of the internal parameters and/or one or more of the external variables, and wherein the functional or tabular relation guaranties that the constraints of the constraint model are satisfied during a charging time period of the rechargeable battery cell if during the charging time period the charging signal is maintained smaller than or equal to the maximum charging value resulting from the functional or tabular relation,

c) as long as the rechargeable battery cell has not reached an end-of-charge condition, charging the rechargeable battery cell by applying a closed-loop charging method by iteratively performing a sequence of steps i) to iv):

i) measuring one or more of the measurable signals of the rechargeable battery cell,

ii) using a state observer algorithm to estimate one or more of the state variables, wherein the state observer algorithm uses the one or more measured measurable signals as input and provides estimates of the one or more state variables as output,

iii) using the functional or tabular relation for computing the maximum charging value by using at least the estimates of the one or more state variables resulting from step ii) as an input for the functional or tabular relation,

iv) imposing a charging signal to the battery that is equal to or lower than the maximum charging value as determined in step iii).

In embodiments, the charging signal is a charging current and the maximum charging value is a maximum charging current. In other embodiments, the charging signal is a charging voltage applied during charging of the rechargeable battery cell and the maximum charging value is a maximum voltage.

In embodiments, one of the one or more measurable signals is a cell voltage or a cell temperature of the rechargeable battery cell.

In embodiments, in step i) of the closed-loop charging method, a first measured measurable signal is a cell voltage of the rechargeable battery cell and a second measured measurable signal is a cell temperature of the rechargeable battery cell.

In embodiments, the one or more quantities taken as input for the functional or a tabular relation comprises at least one or more of the state variables.

In embodiments, the one or more state variables are any of: a critical-surface-concentration or a state-of-charge.

Advantageously, by pre-defining a suitable relation between a maximum charging current and the states of an electrochemical model of the battery cell, and using a state observer algorithm for determining these states during the charging process based on available measurable signals of the rechargeable battery cell (e.g. voltage, current, temperature), the charging current to be applied can be selected without the need of complicated and time consuming calculations.

Advantageously, as the maximum charging current is defined as the largest current that, if applied, avoids accelerated degradation, the method ensures that the constraints are not violated during the entire time period of charging the battery cell.

In embodiments, the rechargeable battery cell is a Lithium-ion rechargeable battery cell.

An example of a cell degradation phenomena is electrode plating, such as Lithium-plating in Li-ion rechargeable battery cells.

In embodiments, in step iv) of the closed-loop charging method, the charging signal applied is selected to be a percentage P of the maximum charging value, with 50% ≤ P < 100%, preferably 70% ≤ P <100%, more preferably 80% ≤ P < 100%. By taking a percentage P of the maximum charging value that is lower than 100%, e.g. 90%, 80% or 50%, an extra safety margin is built in for taking into account potential uncertainties of the battery model and/or battery model parameters.

In embodiments wherein one of the measurable signals in step i) of closed-loop charging method is a cell temperature, the cell temperature measured is, in addition to the estimates of the one or more state variables resulting from step ii), used in step iii), as an input for the functional or tabular relation.

In embodiments, during charging of the rechargeable battery cell, the charging signal is set to a pre-defined value if the measured cell temperature is above a maximum temperature threshold, preferably the pre-defined value corresponds to zero current.

In embodiments, one of the one or more external variables is a temperature signal and/or wherein one of the one or more internal parameters is a constructive parameter of the battery cell.

In embodiments, the dynamic electrochemical model used by the present method is a reduced electrochemical model, for example the known Equivalent Hydraulic Model (EHM). Typically, the dynamic electrochemical model comprises differential, and/or difference, and/or algebraic equations.

In embodiments, the state observer algorithm is a Kalman filter.

Making use of a finite-dimensional reduced order battery model, e.g. the EHM model, allows working with ordinary differential equations, in contrast to several models as described in the academic world and that characterize the electrodes with differential equations in time and space, i.e. partial differential equations. These proposed methods in the academic world are not realistically usable on typical embedded systems like consumers battery chargers.

The present disclosure is not limited to charging a single rechargeable battery cell. The present disclosure also relates to a method for charging a battery comprising a plurality of rechargeable battery cells connected in series and/or in parallel, wherein the method comprises controlling a charging signal of one or more of the rechargeable battery cells of the battery according to the method of controlling a charging signal of a rechargeable battery cell according to the present disclosure.

In other embodiments, the method of charging a battery having a plurality of rechargeable battery cells connected in series and/or in parallel comprises controlling a charging signal of a group of rechargeable battery cells of the plurality of rechargeable battery cells according to the present method of controlling a charging signal of a rechargeable battery cell.

According to a second aspect of the invention, a device for charging a rechargeable battery module comprising a plurality of battery cells connected in series and/or parallel is provided that comprises a controller configured for implementing the charging method described above.

The charging device for charging a rechargeable battery module comprises one or more computer-readable storage media having at least a computer program comprising command instructions, and a controller adapted to execute the computer program, and wherein the controller, when executing the command instructions of the computer program, controls charging signals applied to the rechargeable battery cells according to the method described above.

In embodiments, the charging device is configured for performing the closed-loop charging method of iteratively performing the sequence of steps i) to iv) at a repetition rate in a range between 0.0035Hz and 1000 Hz, preferably in range between 0.01 Hz and 1000Hz, more preferably in a range between 0.1 Hz and 1000Hz.

Advantageously, by defining a closed form relationship by using e.g. an algebraic function or a tabular relationship between the maximum allowable charging current and for example one or more of the state variables of the model in combination with a state observer algorithm estimating the state variables, a solution with a low computational cost is provided.

The device and method according to the present disclosure can make use of simple mathematical operators to select the maximal charging current for the battery. This makes it different to existing contributions in the literature, which mostly rely on Model Predictive Control that needs to solve an online optimization at each sampling time interval, which is a computationally intensive.

**Short description of the drawings**

These and further aspects of the present disclosure will be explained in greater detail by way of example and with reference to the accompanying drawings in which:

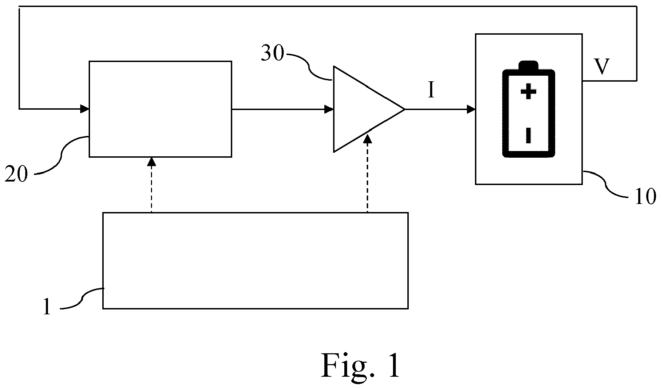

Fig.1    schematically illustrates a closed-loop charging system according to the present disclosure,

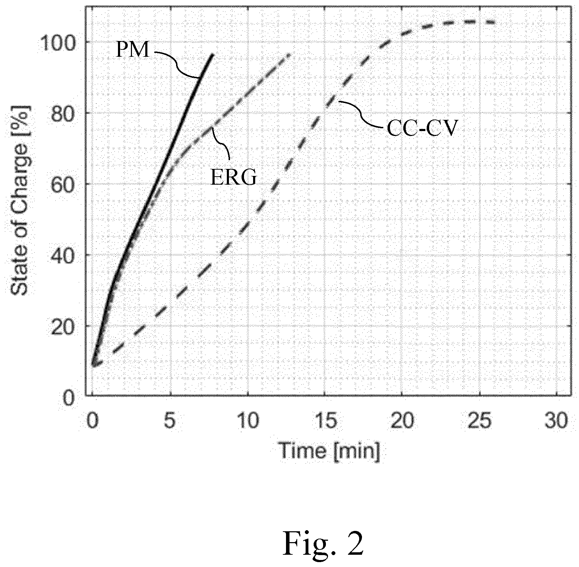

Fig.2    shows an experimental comparison carried out on a commercial battery LCO cell at 30°C wherein a state-of-charge as function of charging time as obtained with an embodiment of the method according to the present disclosure is compared with a state-of-the art constrained-charging method and with a fast CC-CV protocol,

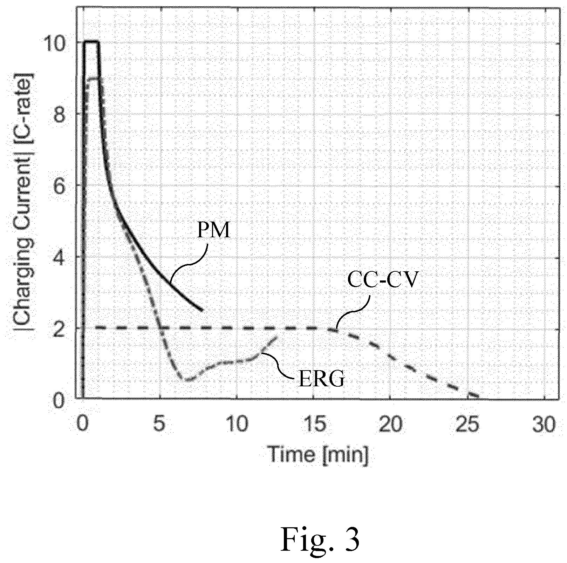

Fig. 3   shows an experimental comparison carried out on a commercial battery LCO cell at 30°C wherein a charging current as function of charging time as obtained with an embodiment of the method according to the present disclosure is compared with a state-of-the art constrained-charging method and with a fast CC-CV protocol,

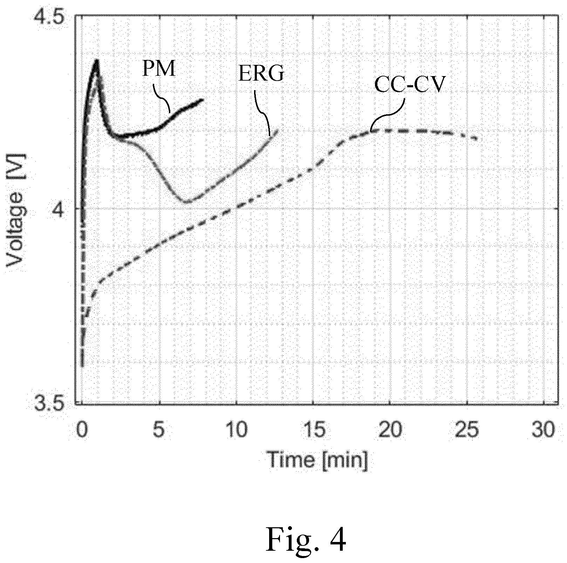

Fig. 4   shows an experimental comparison carried out on a commercial battery LCO cell at 30°C, wherein a cell voltage as function of charging time of an embodiment of the method according to the present disclosure is compared with a state-of-the art constrained-charging method and with a fast CC-CV protocol,

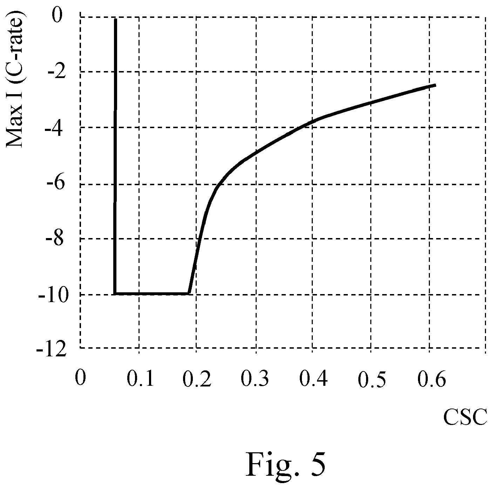

Fig.5    shows a relation between a maximum charging current and one of the internal state variables of an electrochemical model according to the present disclosure.

The drawings of the figures are neither drawn to scale nor proportioned. Generally, identical components are denoted by the same reference numerals in the figures.

**Detailed description of embodiments**

The present disclosure will be described in terms of specific embodiments, which are illustrative of the disclosure and not to be construed as limiting. It will be appreciated by persons skilled in the art that the present disclosure is not limited by what has been particularly shown and/or described and that alternatives or modified embodiments could be developed in the light of the overall teaching of this disclosure. The drawings described are only schematic and are non-limiting.

Use of the verb "to comprise", as well as the respective conjugations, does not exclude the presence of elements other than those stated. Use of the article "a", "an" or "the" preceding an element does not exclude the presence of a plurality of such elements.

Furthermore, the terms first, second and the like in the description and in the claims, are used for distinguishing between similar elements and not necessarily for describing a sequence, either temporally, spatially, in ranking, or in any other manner. It is to be understood that the terms so used are interchangeable under appropriate circumstances and that the embodiments of the disclosure described herein are capable of operation in other sequences than described or illustrated herein.

Reference throughout this specification to "one embodiment" or "an embodiment" means that a particular feature, structure or characteristic described in connection with the embodiments is included in one or more embodiment of the present disclosure. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one ordinary skill in the art from this disclosure, in one or more embodiments.

### Definitions

A rechargeable battery cell is to be construed as an electrochemical storage device that can be charged and discharged multiple times, i.e. the electrochemical process occurring during discharging can be at least partially reversed during charging. An example is a rechargeable Li-ion battery cell. In embodiments, a rechargeable battery, also named battery pack, is formed by connecting a plurality of rechargeable battery cells in series and/or parallel.

A dynamic electrochemical model of a battery or of a battery cell has to be construed as a mathematical model that at least describes the dynamic behaviour of a charging process of the battery or of the battery cell. The electrochemical model comprises one or more state variables such as, but not limited to, a critical-surface-concentration (CSC) and a state-of-charge (SOC). During the charging process, these state variables vary as function of time and hence these internal state variables describe the dynamic behaviour of the battery or of the battery cell.

A state observer is designed as a mathematical algorithm receiving sampled measured data and performs estimates at a given sampling frequency of the actual value of one or more state variables of the electrochemical model. The measured data can for example be the voltage of a battery or battery cell during a charging cycle.

In embodiments, the state observer estimates a model vector state including the SOC variable and the CSC variable. An example of a known state observer suitable for estimating the internal state variables of an electrochemical model is the Kalman filter, known in the art.

### Method for charging a rechargeable battery cell. general

The present method relates to controlling a charging signal applied to a rechargeable battery cell for charging the rechargeable battery cell. The method of the present disclosure comprises a closed-loop control system and/or method for charging a rechargeable battery cell 10, as schematically illustrated on Fig.1. The charging signal applied to the battery cell is for example a charging current, as schematically illustrated on Fig.1 with reference I.

The method provides a dynamic electrochemical model 1 for modelling the charging of the rechargeable battery cell 10.

The dynamic electrochemical model 1 is configured for describing a dynamic behavior of one or more state variables of the dynamic electrochemical model and of one or more measurable signals of the rechargeable battery cell, and wherein the dynamic electrochemical model comprises a constraint model defining constraints on one or more quantities. The one or more quantities are any of but not limited to: one or more of the state variables, the charging signal, one or more internal parameters and/or one or more external variables. The constraints describe battery cell operational regions which avoid or limit occurrence of battery cell degradation phenomena, such as, but not limited to, Lithium-plating in Li-ion battery cells.

In embodiments, the constraints are expressed as functional or tabulated inequalities.

The method further comprises defining a functional or a tabular relation that is taking as input one or more input quantities and that is providing as output a maximum charging value for the charging signal. The one or more input quantities are any of: one or more of the state variables, one or more of the measurable signals, one or more of the internal parameters and/or one or more of the external variables.

The functional or tabular relation guaranties that the constraints of the constraint model are satisfied during a charging time period of the battery cell if during the charging time period the charging signal is maintained smaller than or equal to the maximum charging value resulting from the functional or tabular relation.

In other words, if maintaining the charging signal to a value which is smaller than or equal the maximum charging value during the charging period of the battery cell, the constraints are guaranteed for the entire charging time period. For example if during the first minute of a charging period a high charging current equal to the maximum charging current is applied to the battery cell, this will not have any negative effect on the further charging process up to the end of charging period.

The functional or tabular relation is defined before starting the charging of the rechargeable cell. During the charging process, by providing the necessary inputs for the functional or tabular relation, the output, i.e. the maximum signal value can easily be computed.

In embodiments, the input for the functional or tabular relation is at least one or more of the state variables.

After establishing the definition of the functional or tabular relation, the charging of the battery cell with the closed-loop control method can be performed.

As long as the rechargeable battery cell 10 has not reached an end-of-charge condition, the method comprises charging the rechargeable battery cell by applying a closed-loop charging method. The closed-loop charging method according to the present disclosure comprises iteratively performing a sequence of steps. A first step comprises measuring one or more of the measurable signals of the rechargeable battery cell. A measured signal can for example be an actual voltage V of the rechargeable battery cell, as schematically illustrated on Fig.1. A second step comprises using a state observer algorithm, illustrated as a square box 20 on Fig.1, for determining one or more of the state variables of the model. The state observer algorithm, e.g. a Kalman filter, is using the one or more measured measurable signals as input and provides estimates of the one or more state variables as output. A third step comprises using the functional or tabular relation, for computing the maximum charging value by using at least the estimates of the one or more state variables resulting from the second step as an input for the functional or tabular relation. Finally a fourth step comprises, imposing a charging signal, indicated with reference I on Fig.1, to the rechargeable battery cell 10 that is equal to or lower than the maximum charging value determined in the third step.

The triangle in Fig.1 schematically illustrates step three and step four.

In embodiments, the charging signal is a charging current. In other embodiments the charging signal can be a charging voltage.

The iteratively-performed sequence of four steps of the closed-loop charging method is repeated at a repetition rate typically ranging between 0.0035 Hz and 1000 Hz, hence the applied charging signal is updated at this repetition rate. In embodiments, the said repetition rate is between 0.01 Hz and 1000 Hz. In further embodiments the said repetition rate is between 0.1 Hz and 1000 Hz.

By repetitively applying the four steps of the closed-loop control charging method, at each sampling time during the charging of the battery cell, the charging current is always optimized to be as high as possible as authorized by the constraint model, thereby limiting degradation phenomena of the rechargeable battery cell.

As mentioned above, the closed loop charging process is applied as long as the end-of-charge condition of the rechargeable battery cell is not reached. In other words, the charging process is stopped when the rechargeable battery cell is charged to a pre-defined level, for example a 95% or a 100% charging level,.

In embodiments, the end-of-charge condition corresponds to a threshold on the battery cell state-of-charge. In these embodiments the state-of-charge (SOC) is one of the state variables of the battery cell model that can be estimated using the state observer algorithm. The charging of the battery cell is stopped when the threshold on the SOC is reached. The threshold on the SOC can for example be 100% with respect to a maximum recommended SOC value $SOC_{max}$ or any other value such as 95% or 97.5% of $SOC_{max}$ for example. As discussed above, the state observer algorithm receives the measured signals as an input for estimating the state variables such as CSC and SOC.

For example, the end-of-charge condition is a threshold for the SOC, namely $SOC_{max}$. In this way during charge for each sampling time k, $SOC(k) \leq SOC_{max}$.

In other embodiments, charging of the rechargeable battery cell is stopped when the measured voltage of the battery cell has reached a threshold voltage.

In embodiments, the method further comprises a control of the battery cell temperature during the charging of the rechargeable battery cell. In these embodiments, one of the measurable signals measured in the first step of the closed-loop charging method is the cell temperature.

In embodiments, in addition to the estimates of the one or more state variables resulting from step ii), also the measured cell temperature is used as an input for the functional or tabular relation. In this way, the maximum signal value is depended on both one or more state variables and on the cell temperature.

In embodiments, if the cell temperature is above a temperature threshold, the charging signal is temporarily set to a pre-defined value. The pre-defined value is for example zero current.

In embodiments, after setting the charging current to a pre-defined value the charging signal, e.g. the charging current, based on the functional or tabular relation is re-applied only if the measured cell temperature has become equal to or smaller than the temperature threshold.

*Defining an electrochemical model for the rechargeable battery cell*

According to the method of the present disclosure, a finite dimensional electrochemical model of the battery cell is provided that comprises one or more model internal state variables such as for example but not limited to SOC, CSC, and core temperature.

With dynamic electrochemical models, generally a dynamic behavior of the one or more state variables and one or more measurable signals of the battery cell is expressed in function of one or more of the following: one or more of the state variables, the charging signal, one or more of internal parameters or one or more of external variables.

An example of a model for the rechargeable battery cell that can be used with the method according to the present disclosure, will be described here below.

In embodiments, the model used for modelling the rechargeable battery cell is a reduced-order model that characterizes the main electrochemical phenomena occurring in the electrodes and the electrolyte of a battery cell. In the exemplary case of a Li-Ion cell, the state of the system is finite and is representative of the relevant Li-ion concentration profiles in electrodes and in the electrolyte, and possibly, of the temperature profile in the cell. The model suitable for modelling the rechargeable battery cell includes a characterization of the electrochemical and physical constraints to be satisfied to avoid dangerous phenomena and accelerated aging of the battery cell.

In embodiments, the Equivalent Hydraulic Model, EHM, can be used for modelling the rechargeable battery cell. Such a model is described in Couto, L. D. and Kinnaert, M., in "Internal and sensor fault detection and isolation for Li-ion batteries" IFAC-PapersOnLine, 51(24), 1431-1438, 2018.

The EHM model is a reduced electrochemical model that describes the dynamic behaviour of a battery cell during a charging process by expressing the variation as function of time t of one or more electrochemical model internal state variables. The model takes the following form:

$$dx/dt = A\,x(t) + B\,I(t) \qquad (1)$$

with x being a state vector with x = [SOC CSC] wherein SOC and CSC are the model internal state variables for state-of-charge and critical surface concentration, and I is the system input, namely the charging current for charging the battery cell.

The time t in equation (1) is expressed as a continuous time but generally, in practice, a digital system is used wherein the time is a sampling time, for example incrementable from a sampling time k to a sampling time k+1. In the equations given throughout this document, the continuous time t can be replaced by a sampling time k when considering a digital system.

The matrices A and B in equation (1) are defined as:

$$A = \begin{bmatrix} 0 & 0 \\ g/(\beta(1-\beta)) & -g/(\beta(1-\beta)) \end{bmatrix}, \quad B = \begin{bmatrix} -\gamma \\ -\gamma/(1-\beta) \end{bmatrix} \qquad (2)$$

Wherein g, β and γ are equivalent hydraulic parameters defined for the specific battery cell to be modelled. In electrochemical terms, g is the inverse of the Li-ion diffusion time constant in the anode, β is the volumetric ratio between the core and the surface of the electrode volume and γ normalizes the applied current to the electrode active area.

A model internal parameter is for example a battery cell constructive parameter.

Depending on the embodiment, internal parameters of the model are deduced from data-sheets, or are identified once and for all for a given battery dell model, e.g. using Least Mean Squares algorithms, or are estimated in real-time and adapted along to the lifespan of the battery cell, e.g. they track the aging of the battery cell.

The output voltage V of the battery cell and any other relevant measurable signals are also modelled by the model. For instance in the EHM model the voltage is described as a nonlinear function consisting of the open circuit voltage $\Delta U = U^+ - U^-$, the surface overpotential $\eta_s^\pm$ and the film resistance $R_f$:

$$V(t) = \Delta U(SOC(t)) + \eta_s^+(SOC(t), I(t)) - \eta_s^-(CSC(t), I(t)) - R_f \times \gamma \times I(t) \qquad (3)$$

wherein $\Delta U$, $\eta_s^+$, and $\eta_s^-$ are nonlinear functions of the internal state variables SOC and CSC, of the current I and possibly of the temperature. All these functions are parameterized with relation to. the system parameters.

The EHM model equation (1) represents a linear time invariant system with a nonlinear output as expressed by model equation (3). In order to avoid or limit the most frequent phenomena and side reactions that might compromise the lifetime and the safe operation of the battery cell, the EHM model comprises a constraint model defining constraints on one or more quantities.

Typically, the constraints are expressed as functional or tabulated inequalities.

Examples of constraints are the following upper and lower bounds on the overpotentials, as expressed by equation (4) and (5), and on the SOC and the CSC, as expressed by equation (6):

$$\eta_{SR}^-(T(t), x(t)) = \eta^-\big(T(t), x(t)\big) + U^-\big(x(t)\big) - U_{SR}^- \geq 0 \qquad (4)$$

$$\eta_{SR}^+(T(t), x(t)) = \eta^+\big(T(t), x(t)\big) + U^+(x(t)) - U_{SR}^+ \leq 0 \qquad (5)$$

$$\begin{bmatrix} SOC(t) \\ CSC(t) \end{bmatrix} \leq \begin{bmatrix} SOC_{max} \\ CSC_{max} \end{bmatrix} \qquad (6)$$

wherein $\eta_{SR}^+(T(t), x(t))$ and $\eta_{SR}^-(T(t), x(t))$ are functions that are specific to the battery cell chemistry and depend in general on the state of the model, the temperature T, and the systems parameters. Depending on the specific cell chemistry they can be expressed in closed-form, approximated by polynomial or logarithmic functions, or known in tabulated form. In respectively equation (4) and (5), $U_{SR}^-$ and $U_{SR}^+$ are scalars. In equation (6), $SOC_{max}$ and $CSC_{max}$ are the maximum allowable values for respectively SOC and CSC.

In general, many different definitions of model state variables can be used and the present method is not limited to any specific model state variables. The model, considered as the example described above, characterizes the bulk and surface concentrations i.e. SOC and CSC, respectively, in both electrodes of a battery cell. In general, other state variables can be used, including more concentration variables for each electrode, states representative of Li-ion profile concentration in the electrolyte, and states representative of temperature profiles within the battery cell.

Prior art charging protocols presented in the literature determine the charging current by resorting either to some online optimizations method, e.g. Model Predictive Control schemes or to a cascade control scheme with use of add-on to ensure constraint satisfaction, e.g. Reference Governors, while the method of the present disclosure computes the charging current through a closed-form algebraic function or a tabular relation. The determination of the maximum charging current according to the present disclosure is further discussed below.

As discussed above, the method according to the present disclosure comprises a functional or a tabular relation that is taking as input one or more input quantities and that is providing as output a maximum charging value for the charging signal. If the charging signal is a current, the maximum charging value is a maximum charging current.

The functional or tabular relation and resulting maximum charging values, e.g. maximum charging currents, are defined such that if the charging signal is smaller than or equal to the maximum charging value during a charging time period of the battery cell, i.e. at each time instant during the charging time period, the constraints of the constraint model are satisfied during the entire charging time period.

In embodiments, a functional or tabular relation is for example expressed between a maximum charging current and a state-of-charge SOC. In other embodiments, a functional or tabular relation is for example expressed between a maximum charging current and a critical surface concentration CSC.

The input for the functional or tabular expression is however not limited to one or more state variables. Additional input quantities, in addition to one or more state variables, are for example: one or more of the measurable signals, one or more of the internal parameters and/or one or more of the external variables.

In embodiments, a functional or tabular relation between the whole state vector of the used reduced order model and a maximal "safe" charging current is specified. As discussed above, the maximal "safe" charging current is defined such that if the applied charging current is smaller than or equal to this maximal "safe" charging current during a charging time period of the battery cell, the constraints of the constraint model are satisfied during the charging time period.

In Fig.5, a relation between a maximum charging current and an internal state variable of an electrochemical model according to the present disclosure is shown. In this example the state variable of the model used for this relationship is CSC.

The determination of the maximum charging current corresponding to a charging current not to be exceeded when charging the rechargeable battery cell in order to ensure that the constraints of the constraint model are satisfied during the charging time period, depends on the model used for modelling the battery cell.

A nonlimitative example of how this maximal charging current can be computed is reported hereafter for an EHM model. Given the particular structure of the EHM model, it is possible to prove that equation (4) is equivalent to a constraint in the form:

$$I(t) \geq -\phi(T(t), CSC(t)) \qquad (7)$$

Wherein $\phi$ is a function expression of a maximum charging current that is depending on CSC and temperature T. Depending on the specific cell and chemistry, equation (7) can be expressed by a polynomial or logarithmic function, or tabulated. The charging current is by convention a negative current.

Moreover given the specific diffusive form of the EHM model it is possible to prove that during charging, the constraints expressed by equation (6) are satisfied at all time in the future if the current is set to zero whenever CSC(k) = $SOC_{max}$. Moreover it is possible that for many chemistries and for the most usual range of use of the cell equation (5) is a redundant constraint.

Accordingly, it is possible to define the following function for a digital sampled system version:

$$f(CSC(k), T(k)) = \begin{cases} 0 & if\ CSC(k) \geq (1 - \varepsilon_1)SOC_{max} \\ (\varepsilon_2 - 1)\phi\big(T(k), CSC(k)\big) & if\ CSC(k) < (1 - \varepsilon_1)SOC_{max} \end{cases} \qquad (8)$$

where $\varepsilon_1 > 0$ and $\varepsilon_2 > 0$ are parameters that depend on the sampling time. For an adequate choice of $\varepsilon_1 > 0$ and $\varepsilon_2 > 0$ it is possible to prove that any charging current such that $0 \geq I(k) \geq f(CSC(k), T(k))$ ensures constraints satisfaction at all time.

As illustrated above, cfr equation (8), a functional relation is established that, in this example, is taking as input two input quantities, namely the state variable CSC and the temperature T, and is providing as output a maximum charging value, in this example the maximum charging current.

*Closed-loop charging process, state observer*

As discussed above, according to the method of the present disclosure, a closed-loop charging process, schematically illustrated on Fig.1, is applied by iteratively performing a sequence of steps during the charge of a rechargeable battery cell, so as to iteratively control the charging signal, e.g. the charging current, during the charging process of the rechargeable battery cell. The step of using a state observer algorithm 20 for estimating the state variables of the battery model is further discussed in more detail.

An example of a state observer, also named state estimator, that one can use for the EHM model is the Extended Kalman filter, known in the art. This Kalman filter consists of two steps wherein a first step is a prediction step and a second step is a correction step.

The prediction step of the Extended Kalman filter predicts at the k-th time instant the state estimate $\hat{x}_{k+1|k}$ and the covariance of the estimation error $P_{k+1|k}$

$$\hat{x}_{k+1|k} = A \begin{bmatrix} \widehat{SOC}_{k|k} \\ \widehat{CSC}_{k|k} \end{bmatrix} + B\ I_{k+1|k} \qquad (9)$$

$$P_{k+1|k} = AP_{k|k}A^T + Q \qquad (10)$$

The correction step of the Extended Kalman filter corrects the estimation with the measurements obtained at time k as follows:

$$Kobs_{k+1|k+1} = P_{k+1|k}C_{k+1|k+1}{}^T \big(C_{k|k}P_{k+1|k}C_{k|k}^T C_{k|k}{}^T\big)^{-1} + R \qquad (11)$$

$$\hat{x}_{k+1|k+1} = \hat{x}_{k+1|k} + \mathrm{Kobs}_{k+1|k+1}(V_k - h(\hat{x}_{k+1|k}, T(k), I(k))) \qquad (12)$$

$$P_{k+1|k+1} = P_{k+1|k} - \mathrm{Kobs}_{k+1|k+1} C_{k|k} P_{k+1|k} \qquad (13)$$

$$C_{k|k} = \left. \frac{\partial h(x, I)}{\partial x} \right|_{\hat{x}_{k+1|}, w_1 = 0} \qquad (14)$$

$$h(x(k), T(k), I(k)) = V(k), \text{ cfr equation (3)} \qquad (15)$$

Other embodiments of the Kalman Filters can be used, as well as other models, and additional measured signals, e.g. nodes of the temperature profile.

*Adaptive estimation algorithms*

In embodiments, adaptive estimation algorithms are provided for updating the model parameters of the electrochemical model and/or the tabular or functional relation for determining the maximum charging value of the charging signal. This update is performed on the basis of punctual and/or historical measurements of the rechargeable battery cell during charging and discharging cycles.

Hence, during or following the operation of the battery cell, both charging and discharging, the model may be adapted to characterize the change of parameters due to for example aging.

In this regard, the parameters must be re-calculated. Some examples of the parameters that can be modified in case of a Li-Ion cell are the Li-ion diffusion in the electrodes, the parameters characterizing the electrodes, and the film resistance of the solid electrode-electrolyte interfaces. The updated values of such parameters can be obtained for instance by solving an offline least-squares method. Other embodiments can use Kalman Filter-like techniques for the tracking of the parameters of a battery along its lifespan. The new parameters will be used to update both the model used for the state estimation and the relation used to compute the maximum allowable charging current.

*Battery modules*

In embodiments, a battery can be composed of a plurality of battery cells, e.g. battery strings, modules, and packs. In these embodiments, the method might consider an individual EHM for each battery cell in order to characterize the electrochemical phenomena of each cell. Typically, the voltage of each cell has to be measured or estimated indirectly in order to estimate the electrochemical states of each cell. In the case of the thermal model, measurements of the temperature on several parts of a surface of the battery might be used to estimate the temperature profile of each cell and/or across the battery.

In embodiments, the method of charging of a rechargeable battery that comprises a plurality of rechargeable battery cells, comprises controlling a charging signal of one or more of the rechargeable battery cells of the battery according to the method for controlling a charging signal of a rechargeable battery cell as disclosed in the present disclosure and discussed above.

In embodiments wherein an individual EHM for each rechargeable battery cell is provided, the method comprises controlling a charging signal for each of the rechargeable battery cells of the battery according to the method for controlling a charging signal of a rechargeable battery cell as disclosed in the present disclosure and discussed above.

In other embodiments, the method for charging a rechargeable battery that comprises a plurality of rechargeable battery cells comprises controlling a charging signal of a group of rechargeable battery cells of the plurality of rechargeable battery cells according to the method for controlling a charging signal of a rechargeable battery cell as disclosed in the present disclosure and discussed above.

In further embodiments wherein a rechargeable battery comprises a plurality of rechargeable battery cells, the battery is considered as one "equivalent cell". In other words, in these embodiments, the charging signal is applied on the level of a battery and not on the level of a rechargeable battery cell of the battery. In these embodiments, the method for charging a rechargeable battery corresponds to the method of the present disclosure for charging a rechargeable battery cell as discussed above, wherein the wording "rechargeable battery cell" is be replaced by "rechargeable battery".

Hence according to a further aspect of the present disclosure, a method is provided for controlling a charging signal applied to a rechargeable battery for charging the rechargeable battery, and wherein the rechargeable battery comprises a plurality of rechargeable battery cells connected in series and/or in parallel, the method comprising:

a) providing a dynamic electrochemical model for modelling the charging of the rechargeable battery, wherein the dynamic electrochemical model is configured for describing a dynamic behavior of one or more state variables of the dynamic electrochemical model and of one or more measurable signals of the rechargeable battery, and wherein the dynamic electrochemical model comprises a constraint model defining constraints on one or more quantities, wherein the one or more quantities are any of but not limited to: one or more of the state variables, the charging signal, one or more internal parameters and/or one or more external variables, and wherein the constraints describe battery operational regions which avoid or limit the occurrence of one or more battery degradation phenomena,

b) defining a functional or a tabular relation that is taking as input one or more input quantities and that is providing as output a maximum charging value for the charging signal, and wherein the one or more input quantities comprises any of: one or more of the state variables, one or more of the measurable signals, one or more of the internal parameters and/or one or more of the external variables,

and wherein the functional or tabular relation guaranties that the constraints of the constraint model are satisfied during a charging time period of the rechargeable battery if during the charging time period the charging signal is maintained smaller than or equal to the maximum charging value resulting from the functional or tabular relation,

c) as long as the rechargeable battery has not reached an end-of-charge condition, charging the rechargeable battery by applying a closed-loop charging method by iteratively performing the following sequence of steps i) to iv):

    i) measuring one or more of the measurable signals of the rechargeable battery,
    ii) using a state observer algorithm to estimate one or more of the state variables, wherein the state observer algorithm uses the one or more measured measurable signals as input and provides estimates of the one or more state variables as output,
    iii) using the functional or tabular relation for computing the maximum charging value by using at least the estimates of the one or more state variables resulting from step ii) as an input for the functional or tabular relation,
    iv) applying a charging signal to the rechargeable battery that is equal to or lower than the maximum charging value as determined in step iii).

In embodiments of a method for controlling a charging signal applied to a rechargeable battery as disclosed above, the charging signal is a charging current for charging the rechargeable battery and the maximum charging value is a maximum charging current.

In other embodiments of a method for controlling a charging signal applied to a rechargeable battery, the charging signal is a charging voltage and the maximum charging value is a maximum voltage.

In embodiments of a method for controlling a charging signal applied to a rechargeable battery, in step i) of the closed-loop charging method, a first measured measurable signal is a battery voltage. In further embodiments, a second measured measurable signal is for example a battery temperature.

Furthermore, in embodiments wherein the battery results from an interconnection of several cells, such as in a battery module, the present method can be used in conjunction with existing methods to equalize possible operating mismatches between the individual cells.

*Battery chargers*

According to a further aspect of the present disclosure, a charging device for charging a battery comprising one or more rechargeable battery cells is provided. The charging device is also named battery charger.

The charging device comprises one or more computer-readable storage media comprising at least a computer program with command instructions, and a controller adapted to execute the computer program, and wherein the controller, when executing the command instructions of the computer program, controls charging signals applied to the one or more rechargeable battery cells according to the method described above.

In embodiments, the charging device typically comprises a current source configured for supplying a charging current to the one or more rechargeable battery cells and a sensor configured for monitoring the measurable signals of the one or more rechargeable battery cells during charging of the one or more battery cells.

In embodiments, the sensor is a voltage sensor for sensing a battery cell voltage.

The one or more computer-readable storage media can comprise various types of storage media such as for example a random access memory (RAM), a read-only memory (ROM), a flash memory or an EEPROM memory.

In embodiments wherein a rechargeable battery comprising a plurality of rechargeable battery cells is considered as one "equivalent cell", as discussed above, the controller of the battery charger when executing the command instructions of the computer program, controls a charging signal applied to the rechargeable battery according to the method described above for controlling a charging signal applied to a rechargeable battery.

*Performances*

Figures 2 to 4 illustrate results of a study wherein an experimental comparison is made between the method of controlling a charging signal according to the present disclosure and a method of controlling a charging signal using a state-of-the-art constrained-charging protocol, named ERG, and a method of charging using the well-known CC-CV protocol. In figures 2 to 4, curves related to the present method are referenced as PM (present method).

The ERG state-of-the-art constrained-charging protocol is known from A Goldar, R Romagnoli, LD Couto, M Nicotra, M Kinnaert, E Garone, "Low-Complexity Fast Charging Strategies Based on Explicit Reference Governors for Li-Ion Battery Cells", IEEE Transactions on Control Systems Technology, 2020.

The measurements are performed on a commercial LCO (Lithium-Cobalt Oxide) battery cell at 30°C. For the comparison study, a PC was used, with a dual core 2.5 GHz processor and 2 Gb RAM. By using the same computer for the various charging techniques, the computational times per iteration step of the closed-loop charging method can be compared.

The ERG method is a low-computational cost variant of the Reference Governor that is based on invariant arguments to perform low computational cost constrained control. Typically, it is less computationally intensive than the Reference Governor, from which it is derived, and than the Model Predictive Control (MPC) algorithms. Both MPC and the RG need to solve an online optimization at each time interval of the execution of the control law. Instead, the ERG is a nonlinear constrained policy that does not require to solve an online optimization, thus being less computationally intensive. However, the ERG is less performing in terms of charging time, i.e., it charges a battery cell in a longer period of time, and moreover it still requires a non-negligible amount of online computation when compared with the present method as further outlined below.

As discussed above, with the present method, a functional or tabular relation is predefined, i.e. before starting the charging process. An example of predefined relation is a relation between a maximum charging current and a state variable of the model. The LCO battery was first modelled using an EHM model and the maximum charging current determined as function of the CSC state. On Fig.5, the pre-defined maximum current, indicated as Max I, used for the comparison study as function of the CSC internal state variable is shown. The maximum current is here expressed as a negative current in units of C-rate, where the C-rate is the ratio between the charging current and the commercial nominal capacity of the battery cell. The charging current applied during the closed-loop charging process for performing the comparison study was corresponding to the maximum current.

In Fig.2, a state-of-charge SOC as function of charging time as obtained with an embodiment of the method according to the present disclosure is compared with results obtained with a state-of-the art ERG protocol and with a fast version (at 2C) of the CC-CV protocol typically used in industry. As illustrated on Fig.2, when compared to the CC-VV and the ERG protocol, the present method (PM) charges a battery cell in a shorter time. In this example, the end of charge condition for stopping the charging with the present method and with ERG was a 97.5% SOC threshold, i.e. 97.5 % of $SOC_{max}$. With the CC-CV charging protocol the end of charge is based on a measured cell voltage.

In Fig.3, a charging current as function of charging time as obtained with an embodiment of the method according to the present disclosure is compared with results obtained with the state-of-the art ERG protocol and with a fast CC-CV protocol typically used in industry. As illustrated on Fig.3, when compared to ERG, the charging current during the first minute is larger with the present method than with the ERG method. The charging current is here expressed as a positive value in units of C-rate. In the present example, during the first minute the C-rate is ten, which corresponds to the maximum current shown on Fig.5 for a CSC value up to close to 0.2.

Finally, in Fig.4, a cell voltage as function of charging time as obtained with the present charging method is compared with results from the ERG and CC-CV protocol. In this example, with the present method, during the first couple of minutes a high charging current is applied as shown on Fig.3 which results in reaching higher cell voltages during the first couple of minutes, whereafter the cell voltage is decreasing.

In Table 1, a comparison between different charging protocols is shown for what concerns the charging time, expressed in minutes, and the computational time, expressed in milliseconds. The various protocols compared are: the present charging method, the known state-of-the-art constrained-control methods ERG, RG and MPC, and a fast CC-CV charging protocol at a 2C charging rate. The values given for the charging times are for a 50% and 97.5% SOC with respect to $SOC_{max}$.

The computational time is the time required for performing one iteration of a closed-loop charging control. As discussed above, with the present method, this computational time involves performing estimations of one or more state variables, in this example estimating CSC with a Kalman state observer algorithm and computing a maximum charging value based on a functional or tabular relation. In this example, the functional relation of the maximum charging current as function of CSC is illustrated on Fig.5.

As shown on Table 1, with the present method the charging time for charging the battery to 97.5% SOC is reduced from about 26 minutes with the CC-CV method to 7.78 minutes with the present method. As shown on Table 1, with the present method the charging time is also considerably reduced when compared to the ERG method, i.e. a reduction from 12.73 minutes to 7.78 minutes.

For completeness, Table 1 also shows the charging time and computational results obtained with a state-of-the-art MPC charging protocol. As discussed above, in view of the mathematical complexity of the MPC charging protocol, the computational time is, as expected, huge and not suitable for practical applications. In this example, the MPC protocol needs 186 ms compared to 0.094 ms with the present method, i.e. about 1982 times more computational time is needed for PMC when compared to the charging method of the present disclosure. Also when comparing the computational time of the present method with the ERG and RG method, the present method is respectively about 2.72 and 5.56 times faster.

As further shown on Table 1, the charging times for the 50% and 97.5% charging levels as obtained with the present method are similar to the charging times obtained with the MPC charging protocol.

Table 1

| | Charging time [min] | | Computational Time [ms] |
|---|---|---|---|
| | Charge at 50% | Charge at 97.5% | |
| CC-CV | 10.18 | 25.98 | 0.087 |
| MPC | 3.02 | 7.80 | 189.350 |
| RG | 3.12 | 9.08 | 0.523 |
| ERG | 3.30 | 12.73 | 0.256 |
| Present method | 3.02 | 7.78 | 0.094 |

In conclusion, with the present method, the required computational power can be strongly reduced when compared to the use of prior-art methods, which require much longer computational times per iteration of a closed-loop charging control method. At the same time, fast charging times are obtained. As a result, the hardware cost of battery chargers using the present method can be strongly reduced.

**Claims**

1. A method for controlling a charging signal applied to a rechargeable battery cell for charging the rechargeable battery cell, the method comprising:

a) providing a dynamic electrochemical model for modelling the charging of the rechargeable battery cell, wherein the dynamic electrochemical model is configured for describing a dynamic behavior of one or more state variables of the dynamic electrochemical model and of one or more measurable signals of the rechargeable battery cell, and wherein the dynamic electrochemical model comprises a constraint model defining constraints on one or more quantities, wherein the one or more quantities are any of but not limited to: one or more of the state variables, the charging signal, one or more internal parameters and/or one or more external variables, and wherein said constraints describe battery cell operational regions which avoid or limit the occurrence of one or more battery cell degradation phenomena,
b) defining a functional or a tabular relation that is taking as input one or more input quantities and that is providing as output a maximum charging value for the charging signal, and wherein the one or more input quantities comprises any of: one or more of the state variables, one or more of the measurable signals, one or more of the internal parameters and/or one or more of the external variables, and wherein the functional or tabular relation guaranties that the constraints of the constraint model are satisfied during a charging time period of the rechargeable battery cell if during the charging time period the charging signal is maintained smaller than or equal to the maximum charging value resulting from the functional or tabular relation,
c) as long as the rechargeable battery cell has not reached an end-of-charge condition, charging the rechargeable battery cell by applying a closed-loop charging method by iteratively performing the following sequence of steps i) to iv):

i) measuring one or more of the measurable signals of the rechargeable battery cell,
ii) using a state observer algorithm to estimate one or more of the state variables, wherein the state observer algorithm uses the one or more measured measurable signals as input and provides estimates of the one or more state variables as output,

iii) using said functional or tabular relation for computing the maximum charging value by using at least the estimates of the one or more state variables resulting from step ii) as an input for the functional or tabular relation,

iv) applying a charging signal to the rechargeable battery cell that is equal to or lower than the maximum charging value as determined in step iii).

2. The method according to claim 1, wherein said charging signal is a charging current and wherein said maximum charging value is a maximum charging current, or wherein said charging signal is a charging voltage and said maximum charging value is a maximum voltage.

3. The method according to any of previous claims wherein one of the one or more measurable signals is a voltage or a temperature of the rechargeable battery cell.

4. The method according to any of previous claims wherein one of the one or more external variables is a temperature and/or wherein one of the one or more internal parameters is a battery cell constructive parameter of the battery cell.

5. The method according to any of previous claims wherein said constraints are expressed as functional or tabulated inequalities.

6. The method according to any of previous claims wherein said dynamic behaviour of the one or more state variables and the one or more measurable signals is in function of one or more of the following: one or more of the state variables, the charging signal, one or more of the internal parameters or one or more of the external variables.

7. The method according to any of previous claims wherein in step i) of the closed-loop charging method a first measured measurable signal is a voltage and a second measured measurable signal is a temperature of the rechargeable battery cell.

8. The method according to claim 7, wherein in step iii) of the closed-loop charging method the cell temperature measured in step i) is, in addition to the estimates of the one or more state variables resulting from step ii), used as an input for the functional or tabular relation,
and/or wherein the charging signal is set to a pre-defined value if the measured cell temperature is above a maximum temperature threshold, preferably said pre-defined value corresponds to zero current.

9. The method of any of previous claims, further comprising the following step: d) updating said functional or tabular relation on the basis of historical data obtained during charging and discharging cycles of the rechargeable battery cell and/or based on punctual measurements of the rechargeable battery cell.

10. The method of any of previous claims wherein the one or more state variables are any of: a critical-surface-concentration or a state-of-charge.

11. The method of claim 10 wherein said end-of-charge condition corresponds to a threshold of the state-of-charge such that charging of the rechargeable battery cell is stopped when the threshold of the state-of-charge state is reached.

12. The method according to any of previous claims
wherein said dynamic electrochemical model comprises differential, and/or difference, and/or algebraic equations, and/or wherein said dynamic electrochemical model is a reduced electrochemical model, preferably an Equivalent Hydraulic Model.

13. A method for charging a battery comprising a plurality of rechargeable battery cells, wherein the method comprises :

controlling a charging signal of one or more of the rechargeable battery cells according to the method of any of claims 1 to 12,
or controlling a charging signal of a group of rechargeable battery cells of the plurality of rechargeable battery cells according to the method of any of claims 1 to 12.

14. A method for controlling a charging signal applied to a rechargeable battery for charging the rechargeable battery, wherein the rechargeable battery comprises a plurality of rechargeable battery cells placed in series and/or parallel, the method comprising:

a) providing a dynamic electrochemical model for modelling the charging of the rechargeable battery, wherein the dynamic electrochemical model is configured for describing a dynamic behavior of one or more state variables of the dynamic electrochemical model and of one or more measurable signals of the rechargeable battery, and wherein the dynamic electrochemical model comprises a constraint model defining constraints on one or more quantities, wherein the one or more quantities are any of but not limited to: one or more of the state variables, the charging signal, one or more internal parameters and/or one or more external variables, and wherein said constraints describe battery operational regions which avoid or limit the occurrence of one or more battery degradation phenomena,

b) defining a functional or a tabular relation that is taking as input one or more input quantities and that is providing as output a maximum charging value for the charging signal, and wherein the one or more input quantities comprises any of: one or more of the state variables, one or more of the measurable signals, one or more of the internal parameters and/or one or more of the external variables, and wherein the functional or tabular relation guaranties that the constraints of the constraint model are satisfied during a charging time period of the rechargeable battery if during the charging time period the charging signal is maintained smaller than or equal to the maximum charging value resulting from the functional or tabular relation,

c) as long as the rechargeable battery has not reached an end-of-charge condition, charging the rechargeable battery by applying a closed-loop charging method by iteratively performing the following sequence of steps i) to iv):

i) measuring one or more of the measurable signals of the rechargeable battery,

ii) using a state observer algorithm to estimate one or more of the state variables, wherein the state observer algorithm uses the one or more measured measurable signals as input and provides estimates of the one or more state variables as output,

iii) using said functional or tabular relation for computing the maximum charging value by using at least the estimates of the one or more state variables resulting from step ii) as an input for the functional or tabular relation,

iv) applying a charging signal to the rechargeable battery that is equal to or lower than the maximum charging value as determined in step iii).

15. A charging device for charging a rechargeable battery comprising one or more rechargeable battery cells, the charging device comprising:

• one or more computer-readable storage media comprising at least a computer program comprising command instructions, and

• a controller adapted to execute said computer program, and wherein the controller, when executing the command instructions of the computer program, controls charging signals applied to the one or more rechargeable battery cells according to the method of any of claims 1 to 13 or controls a charging signal applied to the rechargeable battery according to claim 14.

Fig. 1

Fig. 2

Fig. 3

EP 4 057 017 A1

Fig. 4

Fig. 5

EP 4 057 017 A1

Europäisches
Patentamt

European
Patent Office

Office européen
des brevets

# EUROPEAN SEARCH REPORT

**Application Number**

EP 21 16 1626

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/326038 A1 (LEE TAE-KYUNG [US]) 12 November 2015 (2015-11-12) * paragraphs [0031] - [0078]; figures 8,11 * | 1-15 | INV. G01R31/367 H02J7/00 |
| X | OUYANG QUAN ET AL: "Optimal Multiobjective Charging for Lithium-Ion Battery Packs: A Hierarchical Control Approach", IEEE TRANSACTIONS ON INDUSTRIAL INFORMATICS, IEEE SERVICE CENTER, NEW YORK, NY, US, vol. 14, no. 9, 20 September 2018 (2018-09-20), pages 4243-4253, XP011689730, ISSN: 1551-3203, DOI: 10.1109/TII.2018.2825245 [retrieved on 2018-09-05] * paragraph [SectionIIandIII] * | 1-15 | |
| X | SARA MOHAJER ET AL: "Design of a Model-based Fractional-Order Controller for Optimal Charging of Batteries", IFAC-PAPERSONLINE, vol. 51, no. 28, 1 January 2018 (2018-01-01), pages 97-102, XP055739067, DE ISSN: 2405-8963, DOI: 10.1016/j.ifacol.2018.11.684 * paragraphs [Sections1] - [0003]; figures 1,3 * | 1-15 | **TECHNICAL FIELDS SEARCHED (IPC)** G01R H02J |

The present search report has been drawn up for all claims

| Place of search | Date of completion of the search | Examiner |
|---|---|---|
| Munich | 24 August 2021 | Grosse, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 21 16 1626

This annex lists the patent family members relating to the patent documents cited in the above-mentioned European search report.
The members are as contained in the European Patent Office EDP file on
The European Patent Office is in no way liable for these particulars which are merely given for the purpose of information.

24-08-2021

| Patent document cited in search report | Publication date | Patent family member(s) | Publication date |
|---|---|---|---|
| US 2015326038 A1 | 12-11-2015 | CN 105098869 A<br>DE 102015208265 A1<br>US 2015326038 A1 | 25-11-2015<br>07-01-2016<br>12-11-2015 |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **COUTO, L. D. ; KINNAERT, M.** Internal and sensor fault detection and isolation for Li-ion batteries. *IFAC-PapersOnLine,* 2018, vol. 51 (24), 1431-1438

- **A GOLDAR ; R ROMAGNOLI ; LD COUTO ; M NICOTRA ; M KINNAERT ; E GARONE.** Low-Complexity Fast Charging Strategies Based on Explicit Reference Governors for Li-Ion Battery Cells. *IEEE Transactions on Control Systems Technology,* 2020